# EUROPÄISCHE PATENTSCHRIFT

(11) **EP 1 514 375 B1**
(45) Veröffentlichungstag und Bekanntmachung des Hinweises auf die Patenterteilung: **24.01.2007**
(21) Anmeldenummer: 03759848.9
(22) Anmeldetag: 12.06.2003
(51) Int. Cl.: H04L 1/00

(54) **VERFAHREN UND ANORDNUNG ZUR CODIERUNG BZW. DECODIERUNG EINER FOLGE DIGITALER DATEN**
METHOD AND ARRANGEMENT FOR ENCODING AND DECODING A SEQUENCE OF DIGITAL DATA
PROCEDE ET DISPOSITIF DE CODAGE ET DECODAGE D'UNE SEQUENCE DE DONNEES NUMERIQUES

(30) Priorität: 18.06.2002 DE 10227165
(43) Veröffentlichungstag der Anmeldung: 16.03.2005
(73) Patentinhaber: SIEMENS AKTIENGESELLSCHAFT, 80333 München (DE)
(72) Erfinder: PANDEL, Jürgen, 83620 Feldkirchen-Westerham (DE); WAGNER, Marcel, 80335 München (DE); WENG, Wenrong, 85521 Ottobrunn (DE); LIEBL, Günther, 85356 Freising (DE)
(86) Internationale Anmeldenummer: PCT/DE2003/001953
(87) Internationale Veröffentlichungsnummer: WO 2003/107581

(56) Entgegenhaltungen:
- EP-A- 0 996 292
- US-A- 6 055 663
- ROSENBERG J ET AL: "An RTP Payload Format for Reed Solomon Codes" INTERNET CITATION, 3. November 1998 (1998-11-03), XP002242077 Gefunden im Internet: <URL:http://www.ietf.org/proceedings/99jul /i-d/draft-ietf-avt-reedsolomon- 00.txt> [gefunden am 2003-05-20]

## Beschreibung

Die Erfindung betrifft ein Verfahren und eine Anordnung zur Codierung und ein Verfahren und eine Anordnung zur Decodierung einer Folge digitaler Daten.

Aus [1] ist ein Real-time Transfer Protocol (RTP) bekannt, welches die Codierung, Übertragung und Decodierung von Echtzeitdaten, beispielsweise Audio- und Videodaten, regelt. Gemäß [1] beinhaltet ein RTP-Header eine 16 Bit Sequenznummer, die mit jedem RTP-Paket inkrementiert wird. Diese ermöglicht es dem Empfänger, Paketverluste bei der Übertragung zu erkennen und die Pakete in die richtige Reihenfolge zu bringen. Aus Gründen der Datensicherheit wird bei dem ersten Datenpaket eine Zufallszahl als Anfangswert verwendet. Gemäß [1] beinhaltet ein RTP-Header eine Option, die Grenzen von Datenblöcken im Datenstrom durch Setzen von Markerbits zu kennzeichnen.

Aus [2] sind sogenannte Interleaver-Blöcke bekannt, bei denen in einer Codiereinrichtung die Daten zeilenweise in eine Matrix eingelesen und spaltenweise aus der Matrix ausgelesen werden. In einer Decodiereinrichtung wird der gesamte Interleaver-Block wieder zusammengesetzt, bevor die darin enthaltenen Daten verwertet werden.

Aus [3] ist eine Redundanzinformation (auch: Redundanz) bekannt, anhand derer Übertragungsfehler kompensierbar sind. So werden zu übertragende Daten (=Inhaltsdaten) zusätzlich vor der Übertragung über einen gestörten Übertragungskanal mit Redundanzinformation versehen, die aus den zu übertragenden Daten mittels bekannter Verfahren generiert wird. Daraufhin werden die Inhaltsdaten zusammen mit der Redundanzinformation über den Übertragungskanal zu einem Empfänger geschickt. Bei dem Empfänger ist es jetzt möglich, Übertragungsfehler derart auszugleichen, dass anhand der Redundanzinformation die Inhaltsdaten rekonstruiert werden. Dazu werden bekannte Fehlerkorrekturverfahren (siehe [4]) eingesetzt.

In [5] ist ein Verfahren zum ungleichen Fehlerschutz (UXP) von Daten beschrieben, wobei der Fehlerschutz innerhalb eines Datenblocks dadurch variiert wird, dass den Daten unterschiedliche Mengen an Redundanzinformation zugeordnet sind. Gemäß [5] ist eine Anzahl der Datenpakete in einem Datenblock variabel und wird in einem separaten Datenfeld des UXP-Headers, der jedem Datenpaket zugeordnet ist, angegeben.

Die Patentschrift US 6,055,663 beschreibt ein Verfahren, mit dem ein verbessertes fehlerrobustes Multiplexen ermöglicht wird.

Bei der Datenübertragung über fehlerbehaftete Kanäle treten Verluste von Datenpaketen auf. Dies ist insbesondere dann von Nachteil, wenn auch Datenpakete verloren gehen, die jeweils ein Markerbit umfassen, welches die Datenblockgrenze angibt. In diesem Fall ist es vor einer Decodierung der Datenpakete notwendig, die Datenpakete solange zwischenzuspeichern, bis die Positionen der Datenpakete innerhalb der einzelnen Datenblöcke bzw. die Grenzen der verschiedenen Datenblöcke rekonstruiert werden können.

Somit liegt der Erfindung die **Aufgabe** zugrunde, die Rekonstruktion der Grenzen der Datenblöcke zu erleichtern.

Diese Aufgabe wird gemäß den Merkmalen der unabhängigen Patentansprüche gelöst. Weiterbildungen der Erfindung ergeben sich auch aus den abhängigen Patentansprüchen.

Zur Lösung der Aufgabe wird ein Verfahren zur Codierung einer Folge von digitalen Daten angegeben. Ein Teil dieser Folge von digitalen Daten entspricht einem Datenblock und umfasst mehrere Datenpakete. Die Datenpakete eine Kennung, anhand derer die Position des Datenpakets innerhalb des zugehörigen Datenblocks bestimmt wird. Ferner umfassen die Datenpakete jeweils eine Information über die Datenblockbreite. Des Weiteren umfassen pro Datenblock mindestens ein Datenpaket die Kennung und mindestens ein weiteres Datenpaket die Information über die Datenblockbreite. Die Kennung und die Information über die Datenblockbreite werden abwechselnd, insbesondere nach einem vorgebbaren Wiederholungsmuster, in einem Datenfeld übertragen. Die Daten werden unter Berücksichtigung dieser Kennung codiert, wobei anhand der Kennung die Position des Datenpakets innerhalb des jeweiligen Interleaver-Blocks bestimmt wird.

Darüber hinaus wird die Aufgabe durch ein Verfahren zur Decodierung einer Folge von digitalen Daten gelöst. Ein Teil dieser Folge von digitalen Daten entspricht einem Datenblock und umfasst mehrere Datenpakete. Die Datenpakete umfassen eine Kennung, anhand derer die Position des Datenpakets innerhalb des zugehörigen Datenblocks bestimmt wird. Ferner umfassen die Datenpakete jeweils eine Information über die Datenblockbreite. Des Weiteren umfassen pro Datenblock mindestens ein Datenpaket die Kennung und mindestens ein weiteres Datenpaket die Information über die Datenblockbreite. Die Kennung und die Information über die Datenblockbreite werden abwechselnd, insbesondere nach einem vorgebbaren Wiederholungsmuster, in einem Datenfeld übertragen. Die Daten werden unter Berücksichtigung dieser Kennung decodiert , wobei anhand der Kennung die Position des Datenpakets innerhalb des jeweiligen Interleaver-Blocks bestimmt wird.

Ein Vorteil der Erfindung besteht darin, dass die Positionen der empfangenen Datenpakete innerhalb des zugehörigen Datenblocks zu Beginn der Datenübertragung und/oder bei Verlust von Datenpaketen anhand der Kennung unmittelbar bestimmt werden können. Dadurch ist auch eine Echtzeitanwendung, z.B.

Bildtelephonie oder jede andere Multimediaanwendung, ablauffähig, da der Aufwand für die Zwischenspeicherung der Daten erheblich reduziert wird. So kann in der Decodiereinrichtung auch die Größe des Zwischenspeichers für die Daten deutlich reduziert werden oder sogar ganz entfallen. Dadurch, dass nur ein einziges Datenfeld für die Übertragung der Kennung und der Information über die Datenblockbreite benötigt wird, erhöht sich trotz der zwei Funktionalitäten in einem einzelnen Datenfeld die zu übertragende Datenmenge nicht.

Eine Weiterbildung besteht darin, dass die Folge digitaler Daten eine Folge progressiv codierter Daten (=progressive Daten), z.B. progressiv codierte Bilder oder Bilddatenströme, umfasst, wobei die progressiven Daten auch Bilddaten sein können. Progressive Daten sind bezüglich ihres Detaillierungsgrades zeitlich gestaffelt, d.h. anfangs wird bspw. das Bild in einer groben Auflösung übertragen, so dass es zwar darstellbar ist, die Details aber weitgehend unkenntlich sind. Schrittweise werden Verfeinerungen des Bildes übertragen, so dass mit zunehmender Übertragungsdauer die Auflösung des Bildes immer besser wird.

Bei einer zusätzlichen Weiterbildung umfasst der Datenblock Redundanzinformation. So kann ein Fehlerkorrekturverfahren Datenfehler, die bei einer Übertragung aufgetreten sind, korrigieren und die Daten rekonstruieren.

Eine andere Weiterbildung besteht darin, dass anhand der Kennung der Datenpakete ein Anfang und ein Ende des Datenblocks ermittelt werden.

Eine zusätzliche Weiterbildung besteht darin, dass die Anzahl von Datenpaketen mit Kennung derart vorgegeben wird, dass jedes n-te Datenpaket die Kennung erhält.

Eine andere Weiterbildung besteht darin, dass die Anzahl von Datenpaketen mit Kennung derart vorgegeben wird, dass das Datenfeld jedes n-ten Datenpakets die Kennung und ein Teil der restlichen Datenpakete jeweils in ihrem Datenfeld die Datenblockbreite umfassen.

In einer anderen Weiterbildung ist die vorgebbare Anzahl von Datenpaketen mit Kennung jedes zweite Datenpaket.

In einer zusätzlichen Weiterbildung ist der Datenblock ein Interleaver-Block. Dabei werden in der Codiereinrichtung die Daten z.B. zeilenweise in den Interleaver-Block eingelesen und z.B. spaltenweise aus dem Interleaver-Block ausgelesen und anschließend übertragen. Geht bei der Datenübertragung ein Datenpaket, d.h. eine Spalte des Interleaver-Blocks, verloren, so verteilt sich dieser Datenverlust über die Zeilen des Interleaver-Blocks. Beinhalten die Datenzeilen Redundanzinformation, so können diese Fehler bis zu einer bestimmten Anzahl mittels eines Fehlerkorrekturverfahrens korrigiert werden, wobei die Menge der Redundanzinformation direkt die Anzahl der korrigierbaren Fehler beeinflusst.

Eine zusätzliche Weiterbildung besteht darin, dass eine Reihenfolge der Datenblöcke identifizierbar ist, insbesondere anhand eines Zeitstempels oder anhand einer fortlaufenden Nummer. Der Zeitstempel ist eine digitale Kennzeichnung, die beispielsweise den Sendezeitpunkt eines Datums, hier des Datenblocks, angibt.

Eine zusätzliche Weiterbildung besteht darin, dass die Kennung zur Ermittlung der Position des Datenpakets innerhalb des Datenblocks eine Sequenznummer ist. Die Sequenznummer ist beispielsweise eine fortlaufende Nummerierung der Datenpakete. Als Anfangswert kann aus Gründen der Datensicherheit eine Zufallszahl oder auch eine Zahl "0" oder "1" gewählt werden.

In einer zusätzlichen Weiterbildung wird ein Real-time Transfer Protocol (RTP) verwendet. RTP stellt Dienste zur Verfügung, um Echtzeitdaten, beispielsweise Multimediadaten, zu übertragen. Zu diesen Diensten gehört die Vergabe von Zeitstempeln und von Sequenznummern an Datenpakete.

Im Rahmen dieser Weiterbildung wird die Sequenznummer des RTP verwendet, um die Kennung zur Ermittlung der Position des Datenpakets innerhalb des Datenblocks zu bestimmen.

Eine zusätzliche Weiterbildung besteht darin, dass ein Verfahren zum ungleichen Fehlerschutz, z.B. UXP, verwendet wird. So werden progressive Daten innerhalb eines Datenblocks jeweils mit einer unterschiedlichen Menge an Redundanzinformation versehen, um insbesondere zu berücksichtigen, dass die progressiven Daten einer darzustellenden Einheit, z.B. eines Bildes, aufeinander aufbauen, d.h. bei der Verteilung der Redundanzinformation sind die unterschiedlichen Stufen der Progression zu berücksichtigen. Viel Redundanzinformation ist zu Beginn der progressiven Daten zweckmäßig während mit zunehmender Detaillierung immer weniger Redundanzinformation vorgesehen werden kann. Die Anzahl der Datenpakete in einem Datenblock, die sogenannte Datenblockbreite, kann pro Datenblock variieren.

Zur Verwendung desselben Datenfeldes für die Kennung zur Ermittlung der Position des Datenpakets innerhalb des Datenblocks und für die Datenblockbreite, ist vorzugsweise die Größe der Kennung an die Größe dieses Datenfeldes anzupassen. Hat beispielsweise das Datenfeld für die Datenblockbreite eine Größe von 8 Bit und wird die Kennung aus einer 16 Bit langen Sequenznummer des RTP-Headers bestimmt, so kann aus der 16 Bit-Kennung eine 8 Bit-Kennung durch Weglassen der höherwertigen 8 Bit generiert werden.

Weiterhin wird zur Lösung der Aufgabe eine Anordnung zur Codierung einer Folge digitaler Daten angegeben. Bei dieser Anordnung ist eine Prozessoreinheit vorgesehen, die derart eingerichtet ist, dass ein Teil der Folge von digitalen Daten ein Datenblock ist und mehrere Datenpakete umfasst. Die Datenpakete umfassen eine Kennung, anhand derer die Position des Datenpakets innerhalb des zugehörigen Datenblocks bestimmbar ist. Ferner umfassen die Datenpakete jeweils eine Information über die Datenblockbreite. Des Weiteren umfassen pro Datenblock mindestens ein Datenpaket die Kennung und mindestens ein weiteres Datenpaket die Information über die Datenblockbreite. Die Kennung und die Information über die Datenblockbreite werden abwechselnd, insbesondere nach einem vorgebbaren Wiederholungsmuster, in einem Datenfeld übertragen. Die Daten sind unter Berücksichtigung der Kennung codierbar , wobei anhand der Kennung die Position des Datenpakets innerhalb des jeweiligen Interleaver-Blocks bestimmt wird.

Darüber hinaus wird zur Lösung der Aufgabe eine Anordnung zur Decodierung einer Folge digitaler Daten angegeben. Bei dieser Anordnung ist eine Prozessoreinheit vorgesehen, die derart eingerichtet ist, dass ein Teil der Folge von digitalen Daten ein Datenblock ist und mehrere Datenpakete umfasst. Die Datenpakete umfassen eine Kennung, anhand derer die Position des Datenpakets innerhalb des zugehörigen Datenblocks bestimmbar ist. Ferner umfassen die Datenpakete jeweils eine Information über die Datenblockbreite. Des Weiteren umfassen pro Datenblock mindestens ein Datenpaket die Kennung und mindestens ein weiteres Datenpaket die Information über die Datenblockbreite. Die Kennung und die Information über die Datenblockbreite werden abwechselnd, insbesondere nach einem vorgebbaren Wiederholungsmuster, in einem Datenfeld übertragen. Die Daten sind unter Berücksichtigung der Kennung decodierbar , wobei anhand der Kennung die Position des Datenpakets innerhalb des jeweiligen Interleaver-Blocks bestimmt wird.

Die Anordnungen sind insbesondere geeignet zur Durchführung der erfindungsgemäßen Verfahren oder einer deren vorstehend erläuterten Weiterbildungen.

Auch kann die Erfindung oder jede vorstehend beschriebene Weiterbildung durch ein Computerprogrammerzeugnis realisiert sein, welches ein Speichermedium aufweist, auf welchem ein Computerprogramm gespeichert ist, das auf einem Rechner ablaufbar ist und die Erfindung oder Weiterbildung ausführt.

Ausführungsbeispiele der Erfindung werden nachfolgend anhand der Zeichnung dargestellt und erläutert.

Es zeigen
- Fig. 1: eine Skizze, die das Prinzip eines Interleaver-Blocks veranschaulicht,
- Fig.2: eine Skizze, die ein Verfahren zur Codierung digitaler Daten veranschaulicht,
- Fig.3: eine Skizze, die ein Verfahren zur Decodierung digitaler Daten veranschaulicht,
- Fig.4: den Aufbau eines Übertragungspakets,
- Fig.5: eine Positionsbestimmung der Datenpakete innerhalb von Datenblöcken,
- Fig.6: den Aufbau eines Übertragungssystems,
- Fig.7: eine Prozessoreinheit.

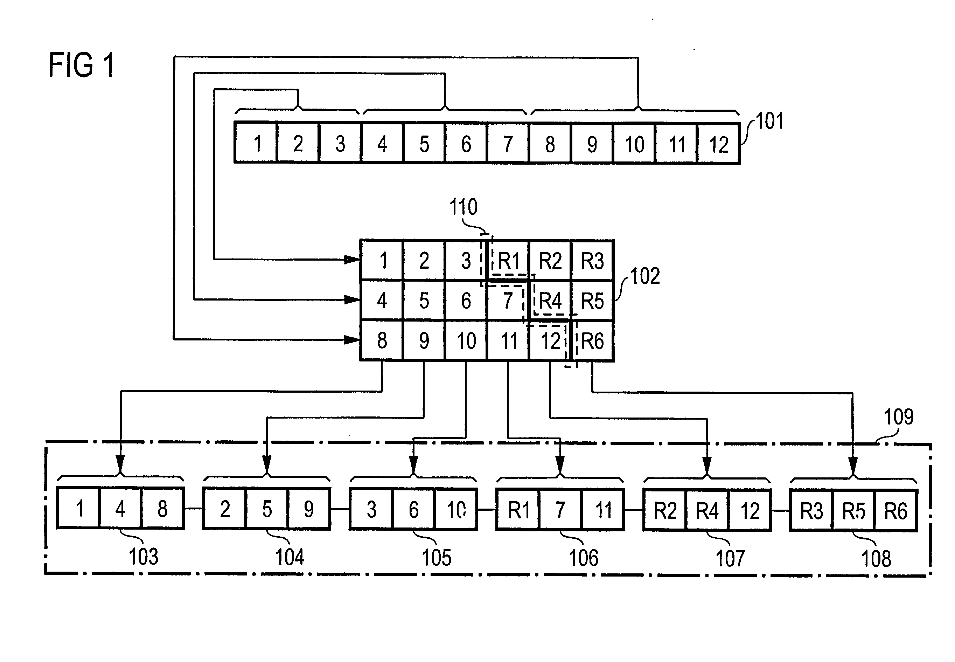

In **Fig. 1** ist eine Skizze gezeigt, die das Prinzip der Funktion eines Interleaver-Blocks veranschaulicht.

Eine progressive digitale Datenfolge 101 mit Daten 1 bis 12 ist beispielhaft in drei Verfeinerungsschritte aufgeteilt, wobei die Daten 1 bis 3 die wichtigsten Daten die Daten 4 bis 7 weniger wichtig sind und schließlich die Daten 8 bis 12 in diesem Beispiel die geringste Bedeutung innerhalb der progressiven Datenfolge 101 aufweisen.

Ein Interleaver-Block 102 umfasst 3 Zeilen und 6 Spalten. Pro Zeile des Interleaver-Blocks 102 werden die Daten eines Verfeinerungsschrittes in dem Interleaver-Block 102 abgelegt und zu den jeweiligen Daten eines Verfeinerungsschritts Redundanzinformation generiert und in dem Interleaver-Block 102 mit abgelegt. In Fig. 1 umfasst der Interleaver-Block drei Zeilen, in der ersten Zeile werden die Daten 1 bis 3 mit Redundanzinformationen R1, R2, R3, in einer zweiten Zeile werden die Daten 4 bis 7 mit Redundanzinformationen R4, R5 und in einer dritten Zeile werden die Daten 8 bis 12 mit Redundanzinformation R6 versehen. Somit können die Daten 1 bis 3 der ersten Zeile des Interleaver-Blocks 102 mit der größten Wahrscheinlichkeit (im Vergleich zu den Daten der jeweiligen anderen beiden Zeilen) rekonstruiert werden, da der ersten Zeile die größte Menge an Redundanzinformation zugeordnet wurde.

Auf diese Weise entsteht in dem Interleaver-Block 102 ein Redundanzprofil 110, welches aus der beschriebenen Verteilung der Daten 1 bis 12 und der erzeugten Redundanzinformationen R1 bis R6 innerhalb des Interleaver-Blocks 102 hervorgeht.

Nachfolgend werden die Daten 1 bis 12 zusammen mit den Redundanzinformationen R1 bis R6 spaltenweise aus dem Interleaver-Block 102 ausgelesen, wobei die Inhalte der Spalten jeweils zu einem Datenpaketen 103 bis 108 zusammengefasst werden: Das Datenpaket 103 umfasst die Daten 1, 4, 8, das Datenpaket 104 umfasst die Daten 2, 5, 9, das Datenpaket 105 umfasst die Daten 3, 6, 10, das Datenpaket 106 umfasst die Redundanzinformation R1 und die Daten 7, 11, das Datenpaket 107 umfasst die Redundanzinformationen R2, R4 und die Daten 12 und das Datenpaket 108 umfasst die Redundanzinformationen R3, R5, R6.

Eine ausgelesene Datenfolge 109 lautet damit: {1, 4, 8}, {2, 5, 9}, {3, 6, 10}, {R1, 7, 11}, {R2, R4, 12}, {R3, R5, R6}.

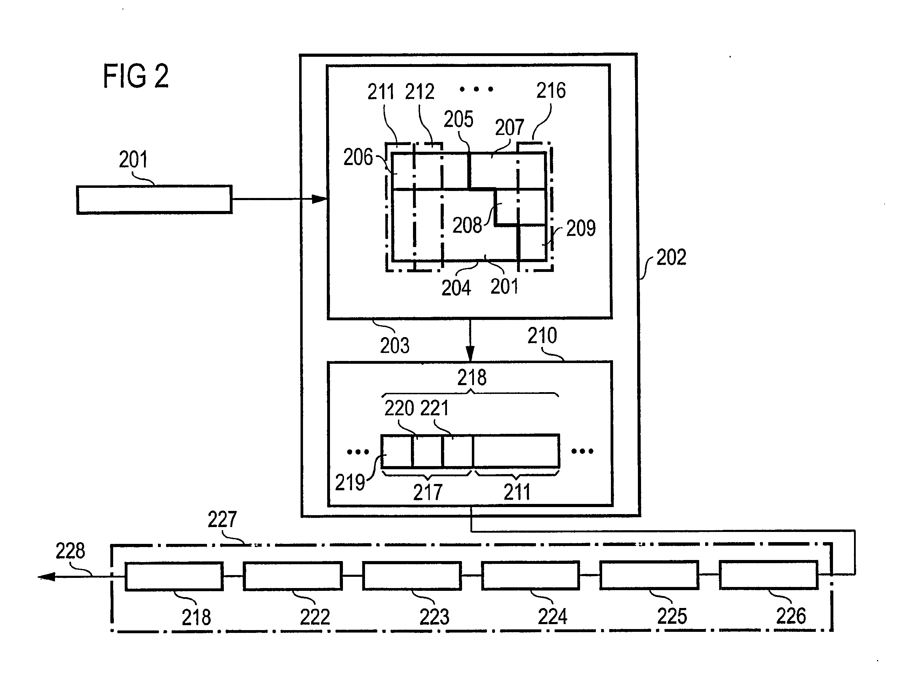

In **Fig. 2** ist eine Skizze gezeigt, die ein Verfahren zur Codierung digitaler Daten veranschaulicht.

Eine Folge von progressiven Daten 201, die hier exemplarisch aus einem Datenblock besteht, wird einer Codiereinheit 202 zugeführt, die eine Optimiereinheit 203 und eine Verpackungseinheit 210 umfasst. Zunächst wird die Folge 201 der Optimiereinheit 203 zugeführt und dort analysiert. Die Analyse liefert eine Struktur der Progression der Daten, anhand der eine Größe eines Interleaver-Blocks 204 und sowie ein Redundanzprofil 205 bestimmt werden. Das Redundanzprofil 205 gehört zu administrative Daten 206, die zur Auswertung des Interleaver-Blocks 204 beim Empfänger notwendig sind. In der Optimiereinheit 203 werden Redundanzinformation 207 für die administrativen Daten 206 und Redundanzinformationen 208, 209 für die digitalen Daten 201 generiert, wobei umso mehr Redundanzinformation vorgesehen wird, je wichtiger die Daten sind, d.h. u.a. abhängig vom Verfeinerungsschritt der Progression (siehe obige Ausführungen).

In den Interleaver-Block 204 werden zuerst die administrativen Daten 206 abgelegt und diesen die meiste Redundanzinformation 207 zugeordnet, um bspw. möglichst viele Übertragungsfehler korrigieren zu können. Nachfolgend wird der Interleaver-Block 204 mit den progressiven Daten 201 und zugehöriger Redundanzinformation 208 und 209 zeilenweise aufgefüllt.

Ist der Interleaver-Block 204 mit Daten und Redundanzinformation gefüllt, so wird der Inhalt des Interleaver-Blocks 204, wie anhand Fig. 1 erläutert, spaltenweise ausgelesen und der Verpackungseinheit 210 zugeführt. In der Verpackungseinheit 210 ist beispielhaft das Verpacken des Inhalts einer Spalte 211 des Interleaver-Blocks 204 gezeigt. So wird das Datenpaket 211, welches den Daten der Spalte 211 entspricht, mit einem Header 217 versehen und zu einem Datenpaket 218 zusammengefasst, welches im folgenden als **Übertragungspaket** 218 bezeichnet wird.

Der Header 217 umfasst ein Feld 219, das eine Sequenznummer für das Übertragungspaket 218 enthält. Zudem umfasst der Header 217 ein Feld 220, in dem abwechselnd eine Kennung, anhand derer die Position des Datenpakets 211 innerhalb des jeweiligen Interleaver-Blocks 204 bestimmt werden kann, oder eine Breite des jeweiligen Interleaver-Blocks 204 angegeben wird. Auch umfasst der Header 217 ein Feld 221, in dem ein Zeitstempel für den jeweiligen Interleaver-Block 204 angegeben wird, wobei jeder Interleaver-Block einer Bildfolge einen anderen Wert als Zeitstempel erhält, so dass einzelne Interleaver-Blöcke voneinander unterscheidbar sind. Hierbei sei angemerkt, dass die Folge digitaler Daten 201 mehrere progressiv codierte Einheiten umfasst, wobei vorzugsweise je eine solche Einheit in einem Interleaver-Block abgelegt wird. Die Interleaver-Blöcke können je nach progressiv codierter Einheit in ihrer Größe variieren. Vorzugsweise werden einzelne Bilder der Folge digitaler Daten 201 progressiv codiert.

Analog zu Spalte 211 werden die restlichen Spalten 212 bis 216 des Interleaver-Blocks 204 zu Übertragungspaketen 222 bis 226 verpackt und zusammen mit Übertragungspaket 218 übertragen. Somit ergibt sich eine codierte Datenfolge 228, die einem Datenblock 227 entspricht. Dieser Datenblock 227 wird auch als Übertragungsblock bezeichnet.

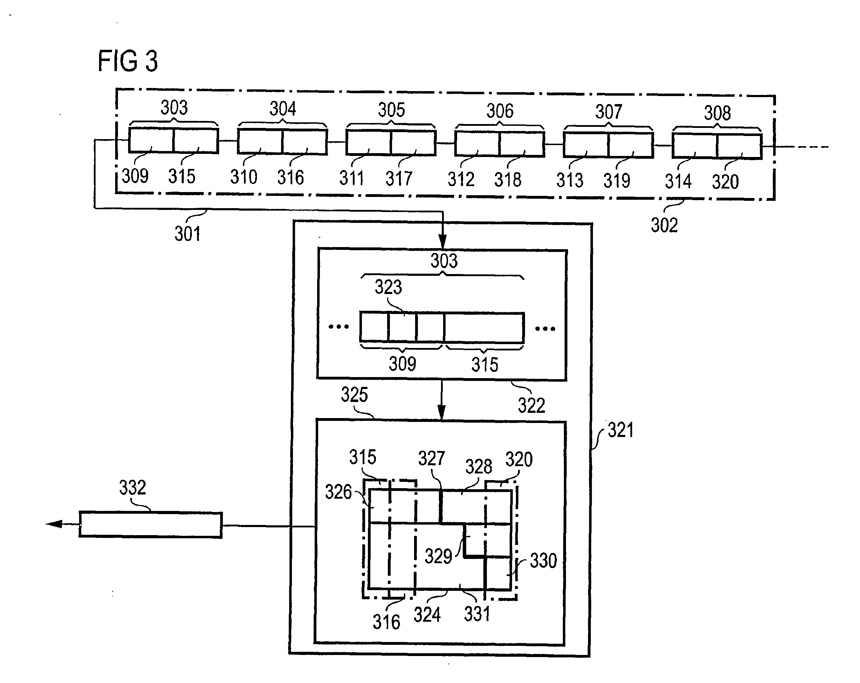

In **Fig. 3** ist ein Verfahren zur Decodierung digitaler Daten dargestellt.

Eine Folge von digitalen Daten 301 enthält einen Datenblock 302, der mehrere Übertragungspakete 303 bis 308 umfasst, wobei jedes Übertragungspaket einen Header und ein Datenpaket aufweist.

So umfasst das Übertragungspaket 303 einen Header 309 und ein Datenpaket 315, das Übertragungspaket 304 einen Header 310 und ein Datenpaket 316, das Übertragungspaket 305 einen Header 311 und ein Datenpaket 317, das Übertragungspaket 306 einen Header 312 und ein Datenpaket 318, das Übertragungspaket 307 einen Header 313 und ein Datenpaket 319 und das Übertragungspaket 308 einen Header 314 und ein Datenpaket 320. Die Folge digitaler Daten, die insbesondere über einen gestörten Übertragungskanal empfangen wurde, wird einer Decodiereinheit zugeführt, die eine Entpackungseinheit 322 und eine Auswerteeinheit 325 beinhaltet.

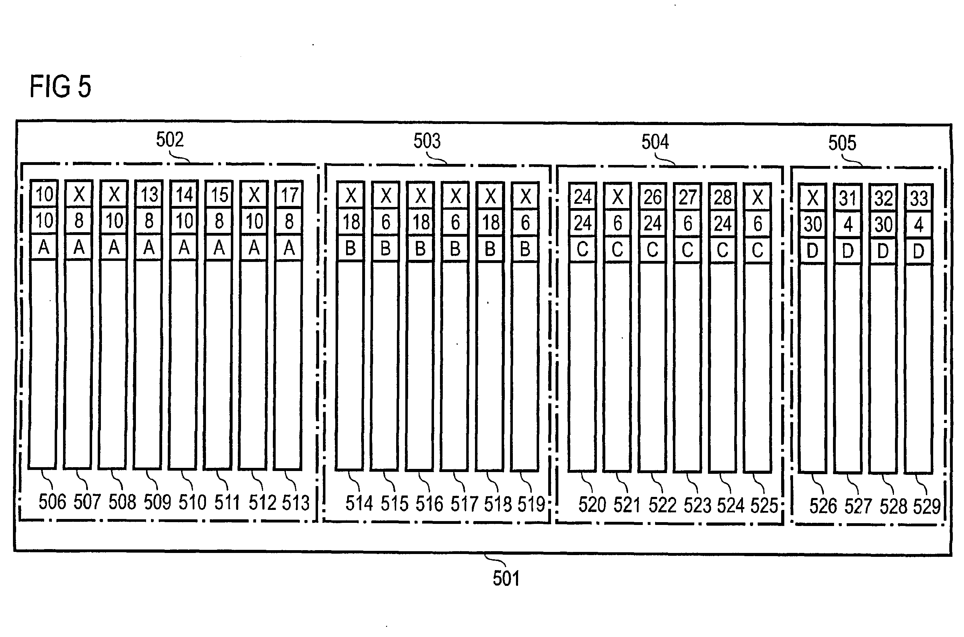

Zunächst werden die Übertragungspakete 303 bis 308 der Entpackungseinheit 322 zugeführt und die Datenpakete 315 bis 320 ausgepackt. Für die Entpackungseinheit 322 ist beispielhaft das Auspacken des Datenpakets 315 aus dem Übertragungspakets 303 gezeigt. So wird zunächst der Header 309 des Übertragungspakets 303 ausgewertet anhand dieses Headers 309, insbesondere anhand der in dem Header enthaltenen Kennung 323, die Spalten-Position des Datenpakets 315 innerhalb eines Interleaver-Blocks 324 bestimmt. Die Problematik der Positionsbestimmung wird nachfolgend in Fig.5 eingehend erläutert.

Das Übertragungspaket 303 wird solange in der Entpackungseinheit 322 zwischengespeichert, bis die Position des Datenpakets 315 in dem Interleaver-Block 324 bestimmt werden kann.

War die Bestimmung der Position des Datenpakets 315 innerhalb des Interleaver-Blocks 324 möglich, so wird das Datenpaket 315 als Spalte in dem Interleaver-Block 324 der Auswerteeinheit 325 abgelegt. Entsprechend wird der Interleaver-Block 324 mit den Datenpaketen 316 bis 320 spaltenweise aufgefüllt.

Anschließend wird der Inhalt des Interleaver-Blocks 324 zeilenweise ausgewertet, z.B. die Bildinformation ausgelesen. Daten 326 umfassen administrative Informationen, anhand derer ein Redundanzprofil 327 für den Interleaver-Block 324 konstruiert werden kann. Mit dem Redundanzprofil ist die Grenze zwischen Inhaltsinformationen, sei es administrativer Art (siehe Daten 326) oder reine Bilddaten (siehe Daten 331) bestimmt.

Sind die Datenpakete 315 bis 320 des Interleaver-Blocks 324 z.B. wegen fehlerhafter Übertragung verloren gegangen, so können diese Fehler (bis zu einer gewissen Häufigkeit, deren obere Grenze durch die Menge der Übertragenen Redundanzinformationen festgelegt ist) durch ein Fehlerkorrekturverfahren in der Auswerteeinheit 325 mit Hilfe der Redundanzinformationen 328, 329 und 330 korrigiert werden, wobei bspw. (nur) der Verlust des Datenpakets 316 bedingt, dass eine Spalte des Interleaver-Blocks 324 wiederhergestellt werden muss, was bei der erläuterten Anordnung der Redundanzinformation zeilenweise möglich ist, wobei insbesondere aufgrund der Progression der Daten sichergestellt sein kann, dass wichtige Daten in dem Datenpaket 316 rekonstruiert werden können, auf unwichtige ggf. verzichtet werden kann, ohne dass die Funktionsfähigkeit des Verfahrens gefährdet wäre. Die ausgelesene digitale Datenfolge 332 kann in einem Bilddecoder, insbesondere einem nach einem Bildkomprimierungs-Standard, wie z.B. MPEG1, MPEG2, MPEG4, H.261, H.263, H.26L, arbeitenden Decoder, weiterverarbeitet werden.

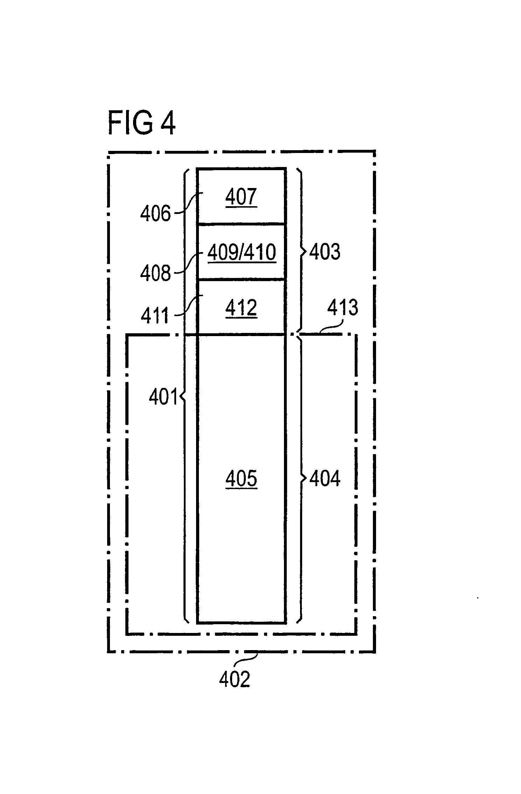

In **Fig. 4** ist der Aufbau eines Übertragungspakets dargestellt. Ein Übertragungspaket 401 eines Übertragungsblocks 402 umfasst einen Header 403 und ein Datenfeld 404, das ein Datenpaket 405 enthält. Der Header 403 umfasst ein Sequenznummernfeld 406, in dem eine Sequenznummer 407 des Übertragungspakets 401 angegeben wird, ein Kennzeichnungsfeld 408, in dem entweder eine Kennung 409 zur Positionsbestimmung des Datenpakets 405 innerhalb des Datenblocks 413 oder eine Breite 410 des Übertragungsblocks 402 angegeben wird und ein Zeitstempelfeld 411, in dem der Wert 412 eines Zeitstempels des Übertragungsblocks 402 angegeben wird.

In **Fig. 5** ist eine Positionsbestimmung der Datenpakete innerhalb von Datenblöcken anhand einer Kennung gezeigt.

Nachfolgend wird gemäß der Nomenklatur der vorangegangen Figuren von einer Positionsbestimmung der Übertragungspakete innerhalb der Übertragungsblöcke ausgegangen. Der Übertragungsblock umfasst mehrere Übertragungspakete, wobei jedes Übertragungspaket einen Header und ein Datenpaket aufweist (siehe Beschreibung zu Fig.2). Ein Datenblock hingegen ergibt sich aus den Datenpaketen des jeweiligen Blocks. Somit umfasst der Übertragungsblock die Übertragungspakete (siehe Fig.4, 401) einschließlich ihrer jeweiligen Header (siehe Fig.4, 403). Die Informationen dieser Header ist zur erwähnten Positionsbestimmung wesentlich.

Eine Datenfolge 501 umfasst Übertragungsblöcke 502, 503, 504 und 505, wobei der Übertragungsblock 502 Übertragungspakete 506 bis 513, der Übertragungsblock 503 Übertragungspakete 514 bis 519, der Übertragungsblock 504 Übertragungspakete 520 bis 525 und der Übertragungsblock 505 Übertragungspakete 526 bis 529 umfasst. Der Aufbau jedes Übertragungspakets ist in Fig.4 beschrieben. Für die Nomenklatur der einzelnen Felder sei daher auf die Beschreibung der Fig.4 verwiesen.

Die zu dem Übertragungsblock 502 gehörenden Übertragungspakete 506 bis 513 sind jeweils im Zeitstempelfeld 411 mit einem Zeitstempelwert "A" gekennzeichnet, die zu Übertragungsblock 503 gehörenden Übertragungspakete 514 bis 519 sind jeweils im Zeitstempelfeld 411 mit einem Zeitstempelwert "B" gekennzeichnet, die zu Übertragungsblock 504 gehörenden Übertragungspakete 520 bis 525 sind jeweils im Zeitstempelfeld 411 mit einem Zeitstempelwert "C" gekennzeichnet und die zu Übertragungsblock 504 gehörenden Übertragungspakete 526 bis 529 sind jeweils im Zeitstempelfeld 411 mit einem Zeitstempelwert "D" gekennzeichnet. Die Übertragungspakete 506 bis 529 beinhalten in ihrem Sequenznummernfeld 406 eine fortlaufende Sequenznummer 407, die für das Übertragungspaket 506 beispielhaft mit "10" beginnt und für das Übertragungspaket 529 mit "33" endet.

In ihrem jeweiligen Kennzeichnungsfeld beinhalten die Übertragungspakete mit geradzahliger Sequenznummer 506, 508, 510, 512, 514, 516, 518, 520, 522, 524, 526, 528 die Kennung zur Positionsbestimmung des Übertragungspakets innerhalb des zugehörigen Übertragungsblocks, wobei hier die Kennung aus der Sequenznummer des jeweils ersten Übertragungspakets im Übertragungsblock besteht, d.h. die Übertragungspakete 506, 508, 510, 512 beinhalten im Kennzeichnungsfeld 408 den Wert "10", die Übertragungspakete 514, 516, 518 beinhalten im Kennzeichnungsfeld 408 den Wert "18", die Übertragungspakete 520, 522, 524 beinhalten im Kennzeichnungsfeld 408 den Wert "24" und die Übertragungspakete 526, 528 beinhalten im Kennzeichnungsfeld 408 den Wert "30". In dem Kennzeichnungsfeld 408 beinhalten die Übertragungspakete mit ungeradzahliger Sequenznummer 507, 509, 511, 513, 515, 517, 519, 521, 523, 525, 527, 529 die jeweilige Übertragungsblockbreite 410, d.h. die Übertragungspakete 507, 509, 511, 513 beinhalten im Kennzeichnungsfeld 408 den Wert "8" für die Breite des Übertragungsblocks 502, die Übertragungspakete 515, 517, 519 beinhalten im Kennzeichnungsfeld den Wert "6" für die Breite des Übertragungsblocks 503, die Übertragungspakete 521, 523, 525 beinhalten im Kennzeichnungsfeld den Wert "6" für die Breite des Übertragungsblocks 504 und die Übertragungspakete 527, 529 beinhalten im Kennzeichnungsfeld 408 den Wert "4" für die Breite des Übertragungsblocks 505.

In Fig. 5 wird angenommen, dass die Übertragungspakete 507, 508 und 512 des Übertragungsblocks 502, die Übertragungspakete 514 bis 519, also der gesamte Übertragungsblock 503, die Übertragungspakete 521 und 525 des Übertragungsblocks 504 und das Übertragungspaket 526 des Übertragungsblocks 505, bei der Datenübertragung verloren gegangen sind. Verlorengegangene Übertragungspakete werden in Fig. 5 durch ein "X" in dem jeweiligen Sequenznummernfeld gekennzeichnet.

Da das letzte Übertragungspaket 519 des Übertragungsblocks 503 nicht empfangen wurde und da die Übertragungsblöcke 502 bis 505 unterschiedliche Übertragungsblockbreiten aufweisen, ist es nicht möglich, den Anfang von Übertragungsblock 504 aus dem Wechsel der Zeitstempelwert "B" zu "C" zu bestimmen, weil sowohl das Übertragungspaket 520, als auch eines der Übertragungspakete 514 bis 519 das erste Übertragungspaket im Übertragungsblock 504 sein könnten. Da die Grenze zwischen Übertragungsblock 503 und Übertragungsblock 504 nicht eindeutig bestimmbar ist, kann ohne oben beschriebene Kennung den empfangenen Übertragungspaketen 520, 522, 523 und 524 ihre Position innerhalb des Übertragungsblocks 504 nicht eindeutig zugewiesen werden. Ist auch das letzte Übertragungspaket 525 des Übertragungsblocks 504 und das erste Übertragungspaket 526 des Übertragungsblocks 505 verloren gegangen, kann ohne Kennung auch das Ende des Übertragungsblocks 504 aus dem Wechsel der Zeitstempelwerte "C" zu "D" nicht eindeutig bestimmt werden, so dass es nötig ist, mehr als einen Übertragungsblock zwischenzuspeichern, bevor die Daten decodiert werden können.

Mit der Kennung im Kennzeichnungsfeld ist es nun möglich, bei Empfang des Übertragungspakets 520 die Sequenznummer "24" und die Kennung "24" miteinander zu vergleichen, woraus folgt, dass es sich hierbei um das erste Übertragungspaket des Übertragungsblocks 504 handelt, da die Kennung "24" mit der Sequenznummer "24" übereinstimmt. Somit können die empfangenen Übertragungspakete 520, 522, 523 und 524 des Übertragungsblocks 504 direkt an der richtigen Positionen innerhalb des Übertragungsblocks 504 abgelegt werden und es ist nicht nötig, diese Übertragungspakete länger zwischenzuspeichern. Geht auch noch das Übertragungspaket 520 mit der Sequenznummer "24" verloren, so kann aus der Kennung "24" des empfangenen Übertragungspakets 522 mit der Sequenznummer "26" sofort die Position dieses Übertragungspakets im Übertragungsblock 504 berechnet werden: 26 - 24 = 2, d.h. es befinden sich in dem Übertragungsblock 504 zwei Übertragungspakete 520 und 521, das empfangene Übertragungspaket 522 ist somit das dritte Übertragungspaket des Übertragungsblocks 504. Auch in diesem Fall ist keine weitere Zwischenspeicherung von Übertragungspaketen des betroffenen Übertragungsblocks notwendig.

In Fig. 5 ist als Kennung die Sequenznummer des ersten Übertragungspakets im jeweiligen Übertragungsblock gewählt worden. Weitere Möglichkeiten bestehen darin, als Kennung den Abstand zum ersten oder letzten Übertragungspaket im jeweiligen Übertragungsblock zu verwenden.

Als weiteres Ausführungsbeispiel wird das 8 Bit lange Datenfeld für die Übertragungsblockbreite aus UXP verwendet, um abwechselnd die Übertragungsblockbreite und die Kennung in den Übertragungspaketen anzugeben. Die Kennung wird aus der 16 Bit langen Sequenznummer des RTP bestimmt, indem die Sequenznummer des ersten Übertragungspakets des jeweiligen Übertragungsblocks von 16 Bit auf 8 Bit reduziert wird. Dies wird beispielsweise dadurch erreicht, dass die höherwertigen zwei Stellen des Hexadezimalcodes gestrichen werden, z.B. von 0xDC36 auf 0x36.

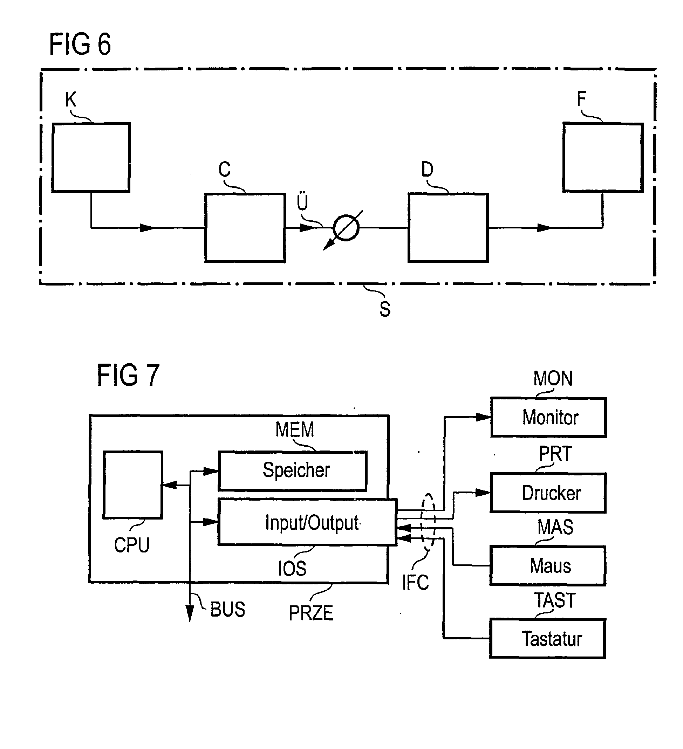

In **Fig. 6** ist der Aufbau eines Übertragungssystems S dargestellt. Das Übertragungssystem S umfasst eine Kamera K, einen Encoder C, einen fehlerbehafteten (gestörten) Übertragungskanal Ü, einen Decoder D und ein Anzeigegerät F. Bilddaten, die von der Kamera K erzeugt werden, werden in dem Encoder C codiert, über den gestörten Übertragungskanal Ü übertragen, von dem Decoder D decodiert und von dem Anzeigegerät F dargestellt. Insbesondere arbeitet der Encoder C und/oder der Decoder D konform nach einem Bildkomprimierstandard, wie z.B. MPEG1, MPEG2, MPEG4, H.261, H.263, H.26L. Encoder und/oder Deocder arbeiten insbesondere unter Berücksichtigung des erfindungsgemäßen Verfahrens.

In **Fig. 7** ist eine Prozessoreinheit PRZE dargestellt. Die Prozessoreinheit PRZE umfasst einen Prozessor CPU, einen Speicher MEM und eine Input/Output-Schnittstelle IOS, die über ein Interface IFC auf unterschiedliche Art und Weise genutzt wird: Über eine Grafikschnittstelle wird eine Ausgabe auf einem Monitor MON sichtbar und/oder auf einem Drucker PRT ausgegeben. Eine Eingabe erfolgt über eine Maus MAS oder eine Tastatur TAST. Auch verfügt die Prozessoreinheit PRZE über einen Datenbus BUS, der die Verbindung von einem Speicher MEM, dem Prozessor CPU und der Input/Output-Schnittstelle IOS gewährleistet. Weiterhin sind an den Datenbus BUS zusätzliche Komponenten anschließbar, z.B. zusätzlicher Speicher, Datenspeicher (Festplatte) oder Scanner.

### Literaturverzeichnis:

[1] H. Schulzrinne, S. Casner, R. Frederick, V. Jacobson: "RTP: A Transport Protocol for Real Time Applications", Kapitel 5.1, RFC 1889, Internet Engineering Task Force, January 1996 (Internet-Adresse vom 28.03.2002: http://www.freesoft.org/CIE/RFC/1889)
[2] A. Falkenberg: "Kodier-/Dekodiervorrichtung zum Durchführen eines Block-Interleaving/Deinterleaving", Patentschrift DE 198 44 140 C1
[3] Duden Informatik, S. 553, Dudenverlag 2001
[4] C. Schuler: "Design and Implementation of an Adaptive Error Control Protocol", Kapitel 2.1, GMD Research Series; 1999, No. 21 (Internet-Adresse vom 25.04.2002: http://www.gmd.de/publications/research/1999/021/)
[5] G. Bäse, G. Liebl: "Generic erasure protection with inband signaling of protection profiles", ITU-Telecommunication Standardization Sector, H.323 Annex I, November 2000 (Internet-Adresse vom 08.04.2002: http://standards.pictel.com/ftp/avc-site/till_0012/0011_Gen/APC-1992.zip)

## Patentansprüche

1. Verfahren zur Codierung einer Folge von digitalen Daten, bei dem
- ein Teil der Folge von digitalen Daten einem Datenblock entspricht,
- der Datenblock mehrere Datenpakete umfasst,
- pro Datenblock mindestens ein Datenpaket eine Kennung und mindestens ein weiteres Datenpaket eine Information über eine Datenblockbreite umfasst, wobei anhand der Kennung die Position des Datenpakets innerhalb des zugehörigen Datenblocks bestimmt wird,
- die Kennung und die Information über die Datenblockbreite abwechselnd in einem Datenfeld übertragen werden, und
- die Daten unter Berücksichtigung der Kennung codiert werden, wobei anhand der Kennung die Position des Datenpakets innerhalb des jeweiligen Interleaver-Blocks bestimmt wird.

2. Verfahren zur Decodierung einer Folge von digitalen Daten, bei dem
- ein Teil der Folge von digitalen Daten einem Datenblock entspricht,
- der Datenblock mehrere Datenpakete umfasst,
- pro Datenblock mindestens ein Datenpaket eine Kennung und mindestens ein weiteres Datenpaket eine Information über eine Datenblockbreite umfassen, wobei anhand der Kennung die Position des Datenpakets innerhalb des zugehörigen Datenblocks bestimmt wird,
- die Kennung und die Information über die Datenblockbreite abwechselnd in einem Datenfeld übertragen werden, und
- die Daten unter Berücksichtigung der Kennung decodiert werden, wobei anhand der Kennung die Position des Datenpakets innerhalb des jeweiligen Interleaver-Blocks bestimmt wird.

3. Verfahren nach Anspruch 1 oder 2,
bei dem die Folge digitaler Daten eine Folge von progressiven Daten umfasst.

4. Verfahren nach einem der vorangehenden Ansprüche,
bei dem die Folge digitaler Daten eine Folge von digitalen Bilddaten umfasst.

5. Verfahren nach einem der vorangehenden Ansprüche,
bei dem der Datenblock Redundanzinformation umfasst.

6. Verfahren nach einem der vorangehenden Ansprüche,
bei dem anhand der Kennung ein Anfang und ein Ende des Datenblocks ermittelt wird.

7. Verfahren nach einem der vorangehenden Ansprüche,
bei dem die Anzahl von Datenpaketen mit Kennung derart vorgegeben wird, dass jedes n-te Datenpaket die Kennung erhält.

8. Verfahren nach einem der Ansprüche 1 bis 6,
bei dem die Anzahl von Datenpaketen mit Kennung derart vorgegeben wird, dass das Datenfeld jedes n-ten Datenpakets die Kennung und ein Teil der restlichen Datenpakete jeweils in ihrem Datenfeld die Datenblockbreite umfassen.

9. Verfahren nach einem der vorangehenden Ansprüche,
bei dem die mindestens zwei Datenpakete mit Kennung jedes zweite Datenpaket sind.

10. Verfahren nach einem der vorangehenden Ansprüche,
bei dem der Datenblock ein Interleaver-Block ist.

11. Verfahren nach einem der vorangehenden Ansprüche,
bei dem eine Reihenfolge der Datenblöcke bestimmt wird.

12. Verfahren nach Anspruch 11,
bei dem eine Reihenfolge der Datenblöcke anhand mindestens eines der folgenden Kriterien bestimmt wird:
- eines Zeitstempels,
- einer fortlaufenden Nummer.

13. Verfahren nach einem der vorangehenden Ansprüche,
bei dem als Protokoll ein Real-time Transfer Protocol (RTP) verwendet wird.

14. Verfahren nach einem der vorangehenden Ansprüche,
bei dem die Kennung zur Ermittlung der Position des Datenpakets innerhalb des Datenblocks eine Sequenznummer ist.

15. Verfahren nach Anspruch 13,
bei dem die Kennung zur Ermittlung der Position des Datenpakets innerhalb des Datenblocks aus der Sequenznummer des RTP ermittelt wird.

16. Verfahren nach einem der vorangehenden Ansprüche,
bei dem ein Verfahren zum ungleichen Fehlerschutz verwendet wird.

17. Verfahren nach Anspruch 16,
bei dem das Verfahren zum ungleichen Fehlerschutz ein UXP-Verfahren ist.

18. Verfahren nach einem der vorhergehenden Ansprüche,
bei dem die Kennung und die Information über die Datenblockbreite abwechselnd nach einem vorgebbaren Wiederholungsmuster in einem Datenfeld übertragen werden.

19. Anordnung zur Codierung einer Folge digitaler Daten, bei der eine Prozessoreinheit vorgesehen ist, die derart eingerichtet ist, dass
- ein Teil der Folge von digitalen Daten ein Datenblock ist,
- der Datenblock mehrere Datenpakete umfasst,
- pro Datenblock mindestens ein Datenpaket eine Kennung und mindestens ein weiteres Datenpaket eine Information über eine Datenblockbreite umfassen, wobei anhand der Kennung die Position des Datenpakets innerhalb des zugehörigen Datenblocks bestimmt wird
- die Kennung und die Information über die Datenblockbreite abwechselnd in einem Datenfeld übertragen werden, und
- die Daten mit diesem Mittel unter Berücksichtigung der Kennung codierbar sind wobei anhand der Kennung die Position des Datenpakets innerhalb des jeweiligen Interleaver-Blocks bestimmt wird.

20. Anordnung zur Decodierung einer Folge digitaler Daten, bei der eine Prozessoreinheit vorgesehen ist, die derart eingerichtet ist, dass
- ein Teil der Folge von digitalen Daten ein Datenblock ist,
- der Datenblock mehrere Datenpakete umfasst,
- pro Datenblock mindestens ein Datenpaket die Kennung und mindestens ein weiteres Datenpaket die Information über die Datenblockbreite umfassen, wobei anhand der Kennung die Position des Datenpaktes innerhalb des dazugehörigen Datenblocks bestimmt wird,
- die Kennung und die Information über die Datenblockbreite abwechselnd in einem Datenfeld übertragen werden, und
- die Daten mit diesem Mittel unter Berücksichtigung der Kennung decodierbar sind wobei anhand der Kennung die Position des Datenpaktes innerhalb des jeweiligen Interleaver-Blocks bestimmt wird.

21. Anordnung nach Anspruch 19 oder 20, bei der eine Prozessoreinheit vorgesehen ist, die derart eingerichtet ist, dass die Kennung und die Information über die Datenblockbreite abwechselnd nach einem vorgebbaren Wiederholungsmuster in einem Datenfeld übertragen werden.

## Claims

1. Method for encoding a sequence of digital data,
wherein
- a portion of the sequence of digital data corresponds to a data block,
- the data block comprises a plurality of data packets,
- at least one data packet per data block contains an identifier and at least one further data packet contains information relating to the data block width, the position of the data packet within the associated data block being determined on the basis of said identifier,
- the identifier and the information relating to the data block width are transmitted alternately in a data field, and
- the data is encoded taking said identifier into consideration, the position of the data packet within the respective interleaver block being determined on the basis of the identifier.

2. Method for decoding a sequence of digital data,
wherein
- a portion of the sequence of digital data corresponds to a data block,
- the data block comprises a plurality of data packets,
- at least one data packet per data block contains an identifier and at least one further data packet contains information relating to the data block width, the position of the data packet within the associated data block being determined on the basis of said identifier,
- the identifier and the information relating to the data block width are transmitted alternately in a data field, and
- the data is decoded taking said identifier into consideration, the position of the data packet within the respective interleaver block being determined on the basis of the identifier.

3. Method according to claim 1 or 2,
wherein the sequence of digital data contains a sequence of progressive data.

4. Method according to one of the preceding claims,
wherein the sequence of digital data contains a sequence of digital image data.

5. Method according to one of the preceding claims,
wherein the data block contains redundancy information.

6. Method according to one of the preceding claims,
wherein a start and an end of the data block are determined by means of the identifier.

7. Method according to one of the preceding claims,
wherein the number of data packets containing an identifier is predefined in such a way that every n-th data packet receives the identifier.

8. Method according to one of claims 1 to 6,
wherein the number of data packets containing an identifier is predefined in such a way that the data field of every n-th data packet contains the identifier and some of the remaining data packets each contain the data block width in their data field.

9. Method according to one of the preceding claims,
wherein the at least two data packets containing an identifier are every other data packet.

10. Method according to one of the preceding claims,
wherein the data block is an interleaver block.

11. Method according to one of the preceding claims,
wherein an order of the data blocks is determined.

12. Method according to claim 11,
wherein an order of the data blocks is determined on the basis of at least one of the following criteria:
- a timestamp,
- a serial number.

13. Method according to one of the preceding claims,
wherein a Real-time Transfer Protocol (RTP) is used as the protocol.

14. Method according to one of the preceding claims,
wherein the identifier for determining the position of the data packet within the data block is a sequential number.

15. Method according to claim 13,
wherein the identifier for determining the position of the data packet within the data block is determined from the sequential number of the RTP.

16. Method according to one of the preceding claims,
wherein an unequal error protection method is used.

17. Method according to claim 16,
wherein the unequal error protection method used is a UXP method.

18. Method according to one of the preceding claims,
wherein the identifier and the information relating to the data block width are transmitted alternately, according to a predefinable repetition pattern, in a data field.

19. Arrangement for encoding a sequence of digital data,
wherein a processor unit is provided which is embodied in such a way that
- a portion of the sequence of digital data is a data block,
- the data block comprises a plurality of data packets,
- at least one data packet per data block contains an identifier and at least one further data packet contains information relating to the data block width, the position of the data packet within the associated data block being determined on the basis of said identifier,
- the identifier and the information relating to the data block width are transmitted alternately in a data field, and
- the data is encodable by these means taking the identifier into consideration, the position of the data packet within the respective interleaver block being determined on the basis of said identifier.

20. Arrangement for decoding a sequence of digital data,
wherein a processor unit is provided which is embodied in such a way that
- a portion of the sequence of digital data is a data block,
- the data block comprises a plurality of data packets,
- at least one data packet per data block contains the identifier and at least one further data packet contains the information relating to the data block width, the position of the data packet within the associated data block being determined on the basis of said identifier,
- the identifier and the information relating to the data block width are transmitted alternately in a data field, and
- the data is decodable by these means taking the identifier into consideration, the position of the data packet within the respective interleaver block being determined on the basis of said identifier.

21. Arrangement according to claim 19 or 20, wherein a processor unit is provided which is embodied in such a way that the identifier and the information relating to the data block width are transmitted alternately, according to a predefinable repetition pattern, in a data field.

## Revendications

1. Procédé pour le codage d'une séquence de données numériques, dans lequel
- une partie de la séquence de données numériques correspond à un bloc de données,
- le bloc de données comprend plusieurs paquets de données,
- par bloc de données au moins un paquet de données comprend un identificateur et au moins un autre paquet de données une information sur une largeur de bloc de données, la position du paquet de données à l'intérieur du bloc de données correspondant étant déterminée à l'aide de l'identificateur,
- L'identificateur et l'information sur la largeur du bloc de données sont transmis alternativement dans une zone de données, et
- les données sont codées en tenant compte de l'identificateur, la position du paquet de données à l'intérieur du bloc imbriqué concerné étant déterminée à l'aide de l'identificateur.

2. Procédé pour le décodage d'une séquence de données numériques, dans lequel
- une partie de la séquence de données numériques correspond à un bloc de données,
- le bloc de données comprend plusieurs paquets de données,
- par bloc de données au moins un paquet de données comprend un identificateur et au moins un autre paquet de données une information sur une largeur du bloc de données, la position du paquet de données à l'intérieur du bloc de données correspondant étant déterminée à l'aide de l'identificateur,
- L'identificateur et l'information concernant la largeur du bloc de données sont transmis alternativement dans une zone de données, et
- les données sont décodées en tenant compte de l'identificateur, la position du paquet de données à l'intérieur du bloc imbriqué concerné étant déterminée à l'aide de l'identificateur.

3. Procédé selon la revendication 1 ou 2,
dans lequel la séquence de données numériques comprend une séquence de données progressives.

4. Procédé selon l'une quelconque des revendications précédentes,
dans lequel la séquence de données numériques comprend une séquence de données d'image numériques.

5. Procédé selon l'une quelconque des revendications précédentes,
dans lequel le bloc de données comprend de l'information redondante.

6. Procédé selon l'une quelconque des revendications précédentes,
dans lequel un début et une fin du bloc de données sont déterminés à l'aide de l'identificateur.

7. Procédé selon l'une quelconque des revendications précédentes,
dans lequel le nombre de paquets de données avec identificateur est prédéfini de telle sorte que chaque n-ième paquet de données reçoit l'identificateur.

8. Procédé selon l'une quelconque des revendications 1 à 6,
dans lequel le nombre de paquets de données avec identificateur est prédéfini de telle sorte que la zone de données de chaque n-ième paquet de données comprend l'identificateur et une partie des paquets des données restants la largeur de bloc de données respectivement dans leur zone de données.

9. Procédé selon l'une quelconque des revendications précédentes,
dans lequel un paquet de données sur deux est un des au moins deux paquets de données avec identificateur .

10. Procédé selon l'une quelconque des revendications précédentes,
dans lequel le bloc de données est un bloc imbriqué.

11. Procédé selon l'une quelconque des revendications précédentes,
dans lequel un ordre de succession des blocs de données est déterminé.

12. Procédé selon la revendication 11,
dans lequel un ordre de succession des blocs de données est déterminé à l'aide d'au moins l'un des critères suivants :
- un cachet de temps,
- un numéro d'ordre continu.

13. Procédé selon l'une quelconque des revendications précédentes,
dans lequel on utilise comme protocole un Real-time Transfert Protocol (RTP).

14. Procédé selon l'une quelconque des revendications précédentes,
dans lequel l'identificateur pour déterminer la position du paquet de données à l'intérieur du bloc de données est un numéro de séquence.

15. Procédé selon la revendication 13,
dans lequel l'identificateur pour déterminer la position du paquet de données à l'intérieur du bloc de données est déterminé à partir du numéro de séquence du RTP.

16. Procédé selon l'une quelconque des revendications précédentes,
dans lequel un procédé pour la protection inégale contre les erreurs est utilisé.

17. Procédé selon la revendication 16,
dans lequel le procédé pour la protection inégale contre les erreurs est un procédé UXP.

18. Procédé selon l'une quelconque des revendications précédentes,
dans lequel l'identificateur et l'information sur la largeur du bloc de données sont transmis alternativement selon un modèle de répétition prédéfinissable dans une zone de données.

19. Dispositif pour le codage d'une séquence de données numériques, sur lequel il est prévu une unité de processeur qui est aménagée de telle sorte que
- une partie de la séquence de données numériques est un bloc de données,
- le bloc de données comprend plusieurs paquets de données,
- par bloc de données au moins un paquet de données comprend un identificateur et au moins un autre paquet de données une information sur une largeur de bloc de données, la position du paquet de données à l'intérieur du bloc de données concerné étant déterminée à l'aide de l'identificateur,
- L'identificateur et l'information sur la largeur du bloc de données sont transmis alternativement dans une zone de données, et
- les données peuvent être codées avec ce moyen en tenant compte de l'identificateur, la position du paquet de données à l'intérieur du bloc imbriqué concerné étant déterminée à l'aide de l'identificateur.

20. Dispositif pour le décodage d'une séquence de données numériques, sur lequel est prévue une unité de processeur qui est aménagée de telle sorte que
- une partie de la séquence de données numériques est un bloc de données,
- le bloc de données comprend plusieurs paquets de données,
- par bloc de données au moins un paquet de données comprend l'identificateur et au moins un autre paquet de données l'information sur la largeur du bloc de données, la position du paquet de données à l'intérieur du bloc de données concerné étant déterminée à l'aide de l'identificateur,
- L'identificateur et l'information sur la largeur de bloc de données sont transmis alternativement dans une zone de données, et
- les données peuvent être décodées avec ce moyen en tenant compte de l'identificateur, la position du paquet de données à l'intérieur du bloc imbriqué concerné étant déterminée à l'aide de l'identificateur.

21. Dispositif selon la revendication 19 ou 20, sur lequel il est prévu une unité de processeur qui est aménagée de telle sorte que l'identificateur et l'information sur la largeur du bloc de données sont transmis alternativement selon un modèle de répétition prédéfinissable dans une zone de données.
